# EUROPEAN PATENT APPLICATION

(11) **EP 4 832 739 A1**
(43) Date of publication of application: **28.10.2026**
(21) Application number: 25172040.5
(22) Date of filing: 23.04.2025
(51) Int. Cl.: H10W 44/20, H10W 44/00, H03F 3/195, H03F 3/60, H10W 42/20, H10W 70/685

(54) **HIGH FREQUENCY SEMICONDUCTOR DEVICE AND METHOD THEREFOR**

(71) Applicant: NXP B.V., 5656 AG Eindhoven (NL)
(72) Inventor: ACAR, Mustafa, 5656AG Eindhoven (NL); NANDAGOPAL, Harish, 5656AG Eindhoven (NL); van der HEIJDEN, Mark Pieter, 5656AG Eindhoven (NL)
(74) Representative: Schwarzweller, Thomas

(57) **Abstract**

A method of forming a semiconductor device is provided. The method includes forming a signal pad at an active side of a semiconductor die and forming a plurality of power amplifiers at the active side of the semiconductor die. Each power amplifier of the plurality of power amplifiers includes an output. The output of each power amplifier of the plurality of power amplifiers is interconnected with the signal pad by way of a unique signal trace. The signal pad is configured to function as a power combiner for the plurality of power amplifiers.

## Description

### Background

### Field

This disclosure relates generally to semiconductor device packaging, and more specifically, to high frequency semiconductor devices and methods of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower performance and higher product or system costs. Accordingly, significant challenges exist in accommodating these features and applications while minimizing the impact on semiconductor devices' performance and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified cross-sectional view, an example semiconductor device at a stage of manufacture in accordance with an embodiment.
FIG. 2 illustrates, in a simplified cross-sectional view, an alternative example semiconductor device at a stage of manufacture in accordance with an embodiment.
FIG. 3 illustrates, in a simplified plan view, an example pad configuration of a semiconductor die in accordance with an embodiment.
FIG. 4 illustrates, in a simplified plan view, an alternative example pad configuration of a semiconductor die in accordance with an embodiment.
FIG. 5 illustrates, in a simplified plan view, another alternative example pad configuration of a semiconductor die in accordance with an embodiment.
FIG. 6 illustrates, in a simplified schematic view, an example pad circuit representation in accordance with an embodiment.
FIG. 7 illustrates, in a simplified schematic view, an example tunable capacitor circuit in accordance with an embodiment.
FIG. 8 illustrates, in a simplified schematic view, an example tunable inductor circuit in accordance with an embodiment.

### Detailed Description

Generally, there is provided, a semiconductor device having a low loss die-to-substrate package transition. The semiconductor device includes a semiconductor die mounted on a low-cost package substrate. The semiconductor die includes a die pad configuration formed at an active side having a signal pad substantially surrounded by a plurality of ground pads. The signal pad is configured for propagation of extremely high frequency band signals. The die pad configuration of the semiconductor die employs features to preserve electromagnetic field symmetry and to resonate out parasitic impedances. The signal pad and surrounding plurality of ground pads of the semiconductor die are interconnected with corresponding exposed traces of the package substrate by way of die connectors to form a compact die-to-substrate transition. The package substrate includes ground planes, traces, and vias configured to substantially surround and shield the signal traces to form a coaxial signal path through the package substrate. By forming the semiconductor device in this manner, a virtually loss-less semiconductor die-to-substrate package transition may be realized which allows higher performance at lower costs.

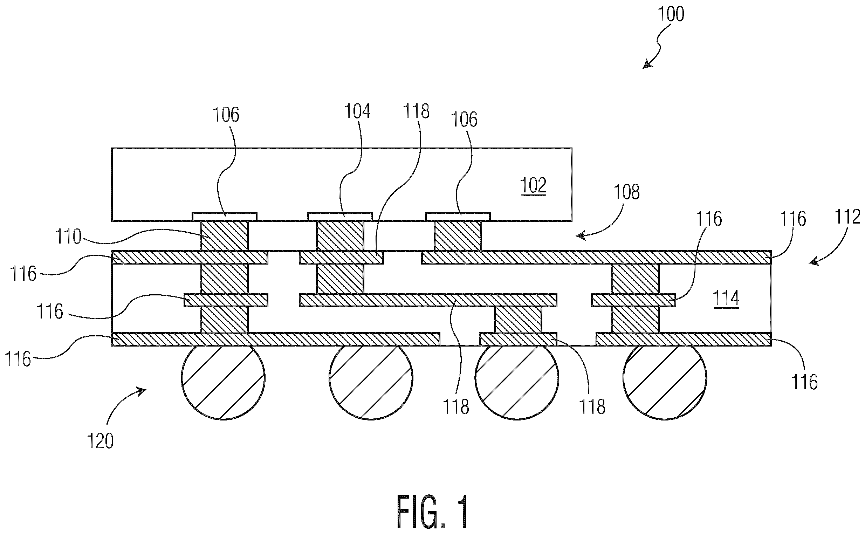

FIG. 1 illustrates, in a simplified top-side-up cross-sectional view, an example semiconductor device 100 at a stage of manufacture in accordance with an embodiment. At this stage, the semiconductor device 100 includes a semiconductor die 102 mounted on a package substrate 112. In this embodiment, the semiconductor die 102 is interconnected with the package substrate 112 by way of conductive die connectors 110. The die connectors 110 may be in the form of suitable conductive structures such as copper pillars, gold studs, solder balls, conductive adhesive, and the like, for example. The term "conductive," as used herein, generally refers to electrical conductivity unless otherwise described. With the semiconductor die 102 interconnected with the package substrate 112, a compact die-to-package-substrate transition 108 is formed. Package features of the semiconductor device 100 such as underfill material, encapsulant, and the like are not shown for illustration purposes.

The semiconductor die 102 has an active side (e.g., major side having circuitry) and a backside (e.g., major side opposite of the active side). The semiconductor die 102 includes die pads 104 and 106 formed at the active side. The term "die pad," as used herein, generally refers to an exposed metal region of the semiconductor die interconnected with circuitry at the active side and configured for connection with a package substrate. In this embodiment, the die pad 104 may be characterized as a signal pad and configured for propagation of mmWave (e.g., 30-300 GHz) radio frequency (RF) signals. The die pads 106 may be characterized as ground pads configured for connection to a ground voltage supply terminal. The die pads 104 and 106 may be referred to herein as signal pad 104 and ground pads 106 respectively. In this embodiment, the plurality of ground pads 106 are configured to substantially surround the signal pad 104 at the active side of the semiconductor die 102. For example, the ground pads 106 are arranged next to one another and proximate to the signal pad 104 (without intervening structures) such that the ground pads 106 surround the signal pad 104 to provide effective shielding. The semiconductor die 102 may be formed from any suitable semiconductor material, such as silicon, germanium, gallium arsenide, gallium nitride, and the like. The semiconductor die 102 may further include RF circuits, digital circuits, analog circuits, power circuits, memories, processors, the like, and combinations thereof at the active side.

The package substrate 112 includes conductive features such as traces 116 and 118 and vias (e.g., vertical connections between traces 116 and 118) surrounded by non-conductive material (e.g., dielectric) 114. The non-conductive material 114 of the package substrate 112 may be formed from materials such as FR4 and other low-cost package substrate materials, for example. The conductive traces 116 and 118 may be formed from patterned metal (e.g., copper) layers separated by dielectric layers (114) of the package substrate 112, for example. The traces 116 may be characterized as ground planes and the traces 118 may be characterized as signal traces (e.g., configured for carrying RF signals). The traces 116 and 118 may be referred to herein as ground planes 116 and signal traces 118 respectively, for example. In this embodiment, the ground planes 116 (and respective vias) are configured to substantially surround and shield the signal traces 118 (and respective vias) to form a coaxial signal path through the package substrate 112. For example, portions of the ground planes 116 are formed on metal layers immediately overlying and underlying the signal traces 118 along with vias (not shown) flanking the signal traces between the overlying and underlying portions of the ground planes.

Portions of the ground plane 116 and signal trace 118 are exposed at a top side of the package substrate 112 and configured for attachment of the die connectors 110. Likewise, portions of the ground plane 116 and signal trace 118 are exposed at a bottom side of the package substrate 112 and serve as conductive connector pads configured for attachment of conductive package connectors 120 (e.g., solder balls or other suitable conductive connectors), for example. In this embodiment, the semiconductor die 102 is configured in an active-side-down orientation with die pads 104 and 106 directly connected to respective ground plane 116 and signal trace 118 of the package substrate 112 by way of the die connectors 110. By forming the semiconductor device 100 with a compact transition 108 and coaxial signal path through the package substrate 112, signal loss at mmWave frequencies may be substantially minimized.

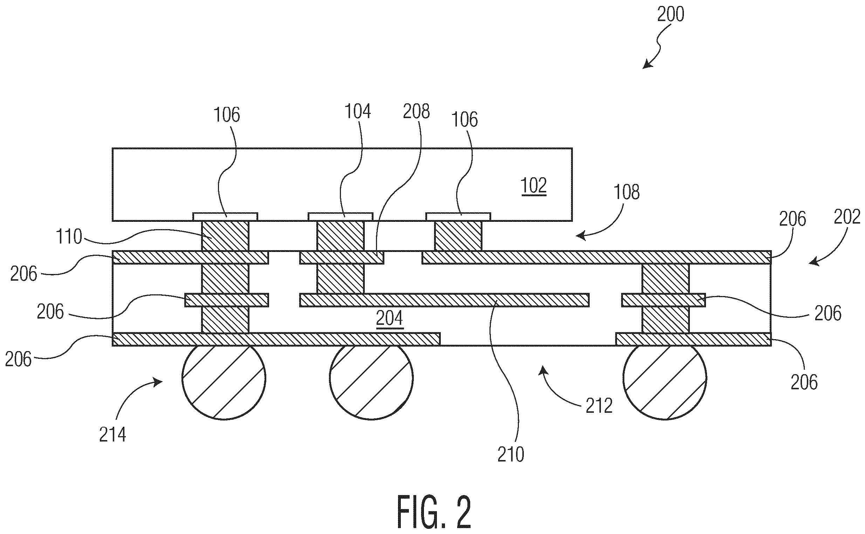

FIG. 2 illustrates, in a simplified top-side-up cross-sectional view, an alternative example semiconductor device 200 at a stage of manufacture in accordance with an embodiment. In this embodiment, the semiconductor device 200 includes the semiconductor die 102 mounted on an alternative package substrate 202. The semiconductor die 102 is interconnected with the package substrate 202 by way of conductive die connectors 110 and forms a compact die-to-package-substrate transition 108. Package features of the semiconductor device 200 such as underfill material, encapsulant, and the like are not shown for illustration purposes.

The package substrate 202 includes conductive features such as traces 206-210 and vias surrounded by non-conductive material 204. The conductive traces 206-210 may be formed from patterned metal layers separated by dielectric layers (204) of the package substrate 202, for example. In this embodiment, traces 206 may be characterized as ground planes and the traces 208 and 210 may be characterized as signal traces. The traces 206 may be referred to herein as ground planes 206 and the traces 208 and 210 may be referred to herein as signal traces 208 and 210, for example. The ground planes 206 (and respective vias) are configured to substantially surround and shield the signal traces 208 and 210 (and respective vias) to form a coaxial signal path through the package substrate 202.

In this embodiment, the signal trace 210 may be characterized as a radiating element configured for wireless propagation of mmWave RF signals. For example, the ground plane 206 above the radiating element 210 may serve as a signal reflector and an opening 212 formed in the ground plane 206 below the radiating element 210 provides a wireless propagation path through the package substrate 202. Even though the package substrate 202 of FIG. 2 is depicted in a "downward-firing" configuration, embodiments in other configurations (e.g., "upward-firing") are anticipated by this disclosure.

Portions of the ground plane 206 and signal trace 208 are exposed at a top side of the package substrate 202 and configured for attachment of the die connectors 110 (e.g., copper pillars, gold studs, solder balls, conductive adhesive, or other suitable connectors). Likewise, portions of the ground plane 206 are exposed at a bottom side of the package substrate 202 and serve as conductive connector pads configured for attachment of conductive package connectors 214 (e.g., solder balls or other suitable conductive connectors), for example. In this embodiment, the semiconductor die 102 is configured in an active-side-down orientation with die pads 104 and 106 directly connected to the respective exposed portions of the ground plane 206 and the signal trace 208 at the top side of the package substrate 106 by way of the die connectors 110. By forming the semiconductor device 200 with a compact transition 108 and coaxial signal path through the package substrate 202, signal loss at mmWave frequencies may be minimized.

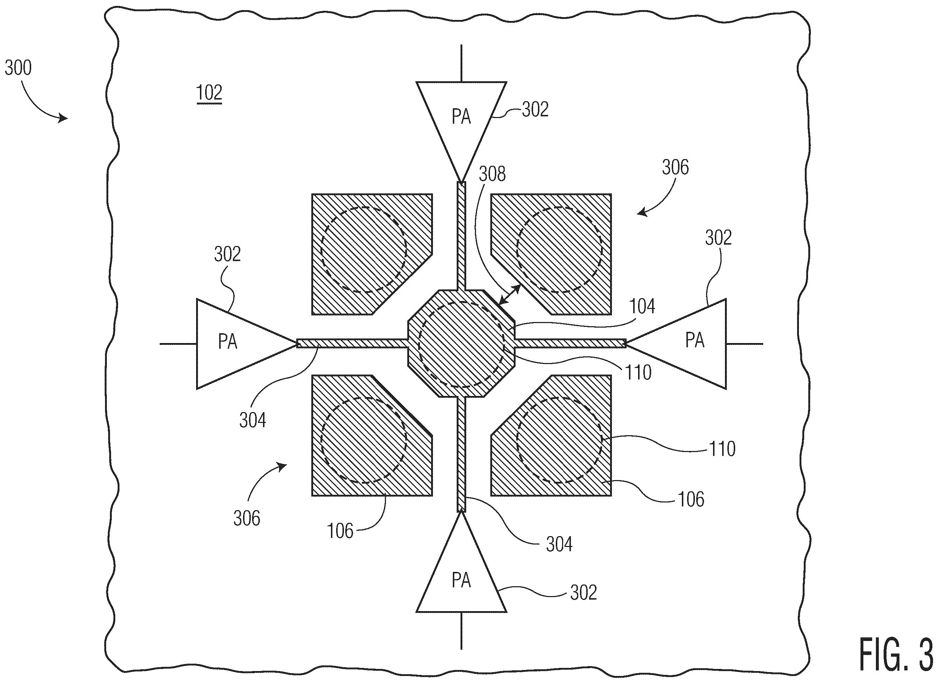

FIG. 3 through FIG. 5 illustrate, in simplified active-side-up plan views, example pad configurations of the semiconductor die 102 in accordance with embodiments. Each of the plan views depicted in FIG. 3 through FIG. 5 include a focused portion of the semiconductor die 102 including a signal pad and surrounding ground pads corresponding to the cross-sectional views depicted in FIG. 1 and FIG. 2.

FIG. 3 illustrates, in a simplified active-side-up plan view, an example pad configuration 300 of the semiconductor die 102 in accordance with an embodiment. In this embodiment, the pad configuration 300 of the semiconductor die 102 includes the signal pad 104 surrounded by a plurality of ground pads 106, and a plurality of power amplifiers 302 (labeled PA) interconnected with the signal pad 104. The plurality of ground pads 106 and the signal pad 104 are formed from portions of a patterned metal layer. Each of the ground pads 106 is connected to a portion of a ground plane 306 formed proximate to the signal pad 104, where the portions of the ground plane 306 are separated from one another by non-conductive gaps. In this embodiment, each of the portions of the ground plane 306 has a perimeter edge that is proximate to approximately one-fourth of the circumference of the signal pad 104. The ground pads 106 and the ground plane 306 may be formed from the same patterned conductive layer, in some embodiments. For example, the ground plane 306 may be formed as extended portions of the patterned metal layer connected to the ground pads 106. In this embodiment, the ground plane 306 is configured to substantially surround the signal pad 104 and to be uniformly spaced apart from the signal pad 104 by a predetermined spacing distance 308. As used herein, the term "uniformly spaced" generally means that, around the perimeter of the signal pad 104, the closest portions of the perimeter of the ground plane (306) are located at substantially the same distance (e.g., distances within +/- 10 percent) from the perimeter of the signal pad 104. A plurality of dashed circular outlines 110 (shown for reference) indicate approximate locations of the die connectors 110 affixed to the corresponding die pads of FIG. 1 and FIG. 2. For illustration purposes, semiconductor die details such as passivation openings are not shown.

In this embodiment, the plurality of power amplifiers includes four power amplifiers 302 integrally formed within the semiconductor die 102. Each power amplifier 302 of the plurality of power amplifiers includes an output interconnected with the signal pad 104 by way of a unique (e.g., separate and distinct) signal trace 304. The signal traces 304 are configured to form symmetrical signal paths (e.g., signal paths having the same effective electrical length and impedance) between the outputs of the power amplifiers 302 and the signal pad 104. For example, the four signal traces 304 are arranged 90 degrees apart from one another about the signal pad 104 with each trace having a first end connected at the signal pad and a second end connected at a respective power amplifier output. According to one or more embodiments, the signal pad 104 is configured to function as a power combiner (or power combining node) by combining the outputs of the plurality of power amplifiers 302 at the signal pad 104. By forming the pad configuration 300 of the semiconductor die 102 with the signal pad 104 configured as a power combiner, the symmetrical signal paths 304 allow symmetry in associated electromagnetic fields thus minimizing signal loss at mmWave frequencies.

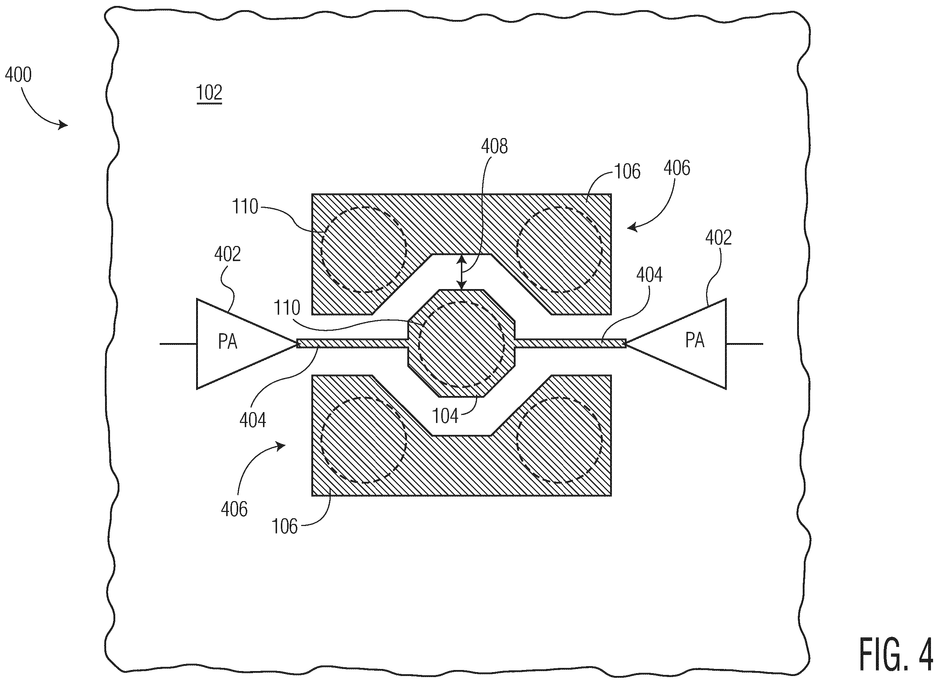

FIG. 4 illustrates, in a simplified active-side-up plan view, an example pad configuration 400 of the semiconductor die 102 in accordance with an embodiment. In this embodiment, the pad configuration 400 of the semiconductor die 102 includes the signal pad 104 surrounded by a plurality of ground pads 106 and a plurality of power amplifiers 402 (labeled PA) interconnected with the signal pad 104. The plurality of ground pads 106 and the signal pad 104 are formed from a patterned metal layer. Each of the ground pads 106 is connected to a portion of a ground plane 406 formed proximate to the signal pad 104, where the portions of the ground plane 406 are separated from one another by non-conductive gaps. In this embodiment, each of the portions of the ground plane 406 has a perimeter edge that is proximate to approximately one-half of the circumference of the signal pad 104. The ground pads 106 and the ground plane 406 may be formed from the same patterned conductive layer, in some embodiments. For example, the ground plane 406 may be formed as extended portions of the patterned metal layer connected to the ground pads 106. In this embodiment, the ground plane 406 is configured to substantially surround the signal pad 104 and to be uniformly spaced apart from the signal pad 104 by a predetermined spacing distance 408. As used herein, the term "uniformly spaced" generally means that, around the perimeter of the signal pad 104, the closest portions of the perimeter of the ground plane (406) are located at substantially the same distance (e.g., distances within +/- 10 percent) from the perimeter of the signal pad 104. A plurality of dashed circular outlines 110 (shown for reference) indicate approximate locations of the die connectors 110 affixed to the corresponding die pads of FIG. 1 and FIG. 2. For illustration purposes, semiconductor die details such as passivation openings are not shown.

In this embodiment, the plurality of power amplifiers includes two power amplifiers 402 integrally formed within the semiconductor die 102. Each power amplifier 402 of the plurality of power amplifiers includes an output interconnected with the signal pad 104 by way of a unique (e.g., separate and distinct) signal trace 404. The signal traces 404 are configured to form symmetrical signal paths (e.g., signal paths having the same effective electrical length and impedance) between the outputs of the power amplifiers 402 and the signal pad 104. For example, the two signal traces 404 are arranged 180 degrees apart from one another about the signal pad 104 with each trace having a first end connected at the signal pad and a second end connected at a respective power amplifier output. In other words, one signal trace 404 is connected at a first side (e.g., left side) of the signal pad 104 and the other signal trace 404 is connected at a second side (e.g., right side) opposite of the first side of the signal pad 104. According to one or more embodiments, the signal pad 104 is configured to function as a power combiner (or power combining node) by combining the outputs of the power amplifiers 402 at the signal pad 104. By forming the pad configuration 400 of the semiconductor die 102 with the signal pad 104 configured as a power combiner, the symmetrical signal paths 404 allow symmetry in associated electromagnetic fields thus minimizing signal loss at mmWave frequencies.

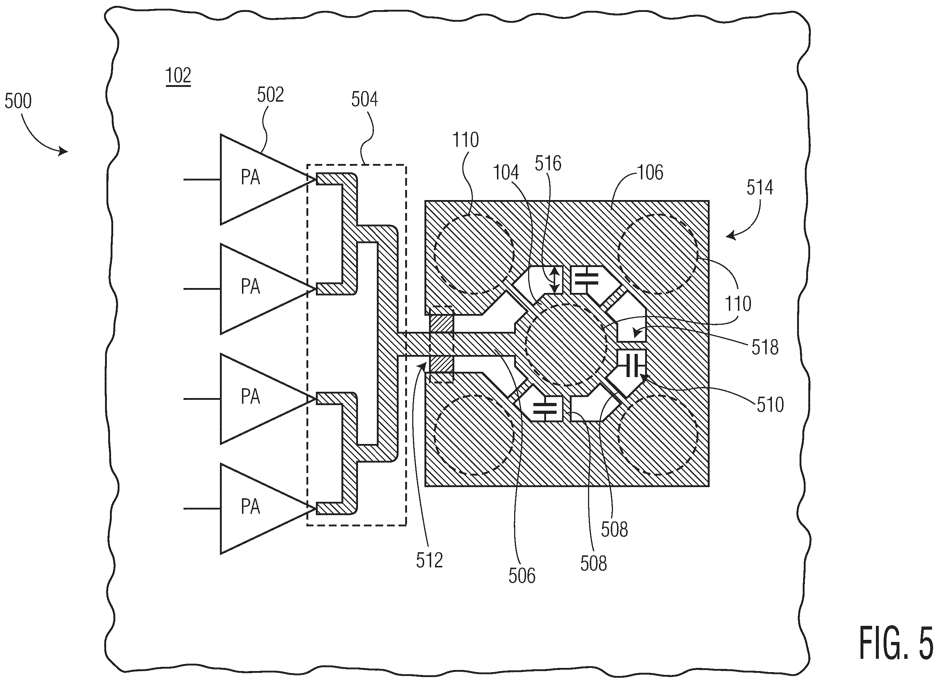

FIG. 5 illustrates, in a simplified active-side-up plan view, an example pad configuration 500 of the semiconductor die 102 in accordance with an embodiment. In this embodiment, the pad configuration 500 of the semiconductor die 102 includes the signal pad 104 surrounded by a plurality of ground pads 106 and a plurality of power amplifiers 502 (labeled PA) interconnected with the signal pad 104. The plurality of ground pads 106 and the signal pad 104 are formed from a patterned metal layer. Each of the ground pads 106 is connected to a portion of a ground plane 514 formed proximate to the signal pad 104. In this embodiment, the ground plane 514 has a perimeter edge that is proximate to a major portion of the circumference of the signal pad 104. The ground pads 106 and the ground plane 514 may be formed from the same patterned conductive layer, in some embodiments. For example, the ground plane 514 may be formed as extended portions of the patterned metal layer connected to the ground pads 106. In this embodiment, the ground plane 514 is configured to substantially surround the signal pad 104 and to be uniformly spaced apart from the signal pad 104 by a predetermined spacing distance 516. As used herein, the term "uniformly spaced" generally means that, around the perimeter of the signal pad 104, the closest portions of the perimeter of the ground plane (514) are located at substantially the same distance (e.g., distances within +/- 10 percent) from the perimeter of the signal pad 104. A plurality of dashed circular outlines 110 (shown for reference) indicate approximate locations of the die connectors 110 affixed to the corresponding die pads of FIG. 1 and FIG. 2. For illustration purposes, semiconductor die details such as passivation openings are not shown.

The plurality of power amplifiers includes four power amplifiers 502 formed at the active side of the semiconductor die 102 in this embodiment. Each power amplifier 502 of the plurality of power amplifiers includes an output (e.g., a drain terminal) interconnected with the signal pad 104 by way of a power combiner network 504 and a transmission line 506. The power combiner network 504 is formed from one or more patterned metal layers of the semiconductor die 102, for example. The power combiner network 504 includes input branches connected to respective outputs of the power amplifiers 502 and an output connected to a distal end of the transmission line 506. The power combiner network 504 is configured to combine the outputs of the power amplifiers 502 at the output. For example, the power combiner network 504 is configured to combine the signals produced at the outputs of the power amplifiers in phase with each other. The transmission line 506 is connected between the power combiner network 504 and the signal pad 104. A proximal end of the transmission line 506 is connected at the signal pad 104 and the distal end of the transmission line 506 is connected at the output of the power combiner network 504. The transmission line 506 is configured for transmission of RF signals at mmWave frequencies.

In this embodiment, the pad configuration 500 of the semiconductor die 102 further includes a tunable inductor 518 connected between the signal pad 104 and the ground plane 514 and a tunable capacitor 512 connected between the transmission line 506 and the ground plane 514. The tunable inductor 518 and the tunable capacitor 512 are formed at the active side of the semiconductor die 102 and are configured for tuning out potential impedance mismatches associated with the semiconductor die-to-package-substrate transition 108 of FIG. 1 and FIG. 2, for example.

The tunable inductor 518 may be formed as one or more patterned trace segments, each trace segment configured as an inductive element 508 having a first terminal (or first end) connected at the signal pad 104 and a second terminal (or second end) connected at the ground plane 514. In some embodiments, the tunable inductor 518, as depicted in FIG. 5, is formed as a plurality of substantially symmetrical trace segments (e.g., inductive elements 508) which extend radially from the signal pad 104 to the ground plane 514. The inductance of the tunable inductor 518, for example, may be tuned or adjusted by increasing or decreasing the number of inductive elements 508 and/or by increasing or decreasing the width of the inductive elements 508. By forming the inductive elements 508 in a radial distribution about the signal pad 104, the parasitic capacitance 510 between the signal pad 104 and the ground plane 514, for example, may be resonated out. The number, size, and arrangement of the inductive elements 508 in the embodiment of FIG. 5 are chosen for illustration purposes. In some embodiments, the tunable inductor 518 may include more or fewer inductive elements 508. In other embodiments, the tunable inductor 518 may include as few as a single inductive element 508, which may be positioned on a side of the signal pad 104 opposite the side of the signal pad 104 to which of the transmission line 506 is connected.

The tunable capacitor 512 is formed as a metal-insulator-metal (MIM) capacitor in this embodiment. The tunable capacitor 512 includes a first terminal (or first plate) connected at the transmission line 506 and a second terminal (or second plate) connected at the ground plane 514. For example, a portion of the transmission line 506 may be configured to function as a first plate of the MIM capacitor 512 with an underlying ground plane portion configured to function as a second plate of the MIM capacitor. The capacitance of the tunable capacitor 512, for example, may be tuned or adjusted by increasing or decreasing the area of the first and second plates of the tunable capacitor 512. In this embodiment, the tunable capacitor 512 is formed at a distal portion of the transmission line 506 and is configured to provide input capacitance for resonating out parasitic impedances associated with the signal pad 104.

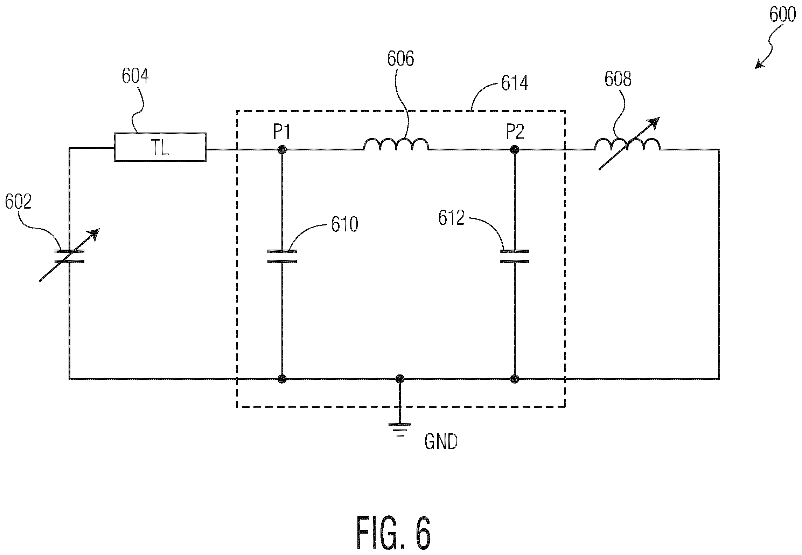

FIG. 6 illustrates, in a simplified schematic view, an example pad circuit model 600 in accordance with an embodiment. The pad circuit model 600 depicted in FIG. 6 is provided as a representation of the example pad configuration 500 of the semiconductor die 102 depicted in FIG. 5, for example. The pad circuit model 600 includes signal pad portion 614 (shown within a dashed outline), a tunable capacitor 602, a transmission line 604, and a tunable inductor 608.

The signal pad portion 614 corresponds to the signal pad 104 of FIG. 5, for example. The signal pad portion 614 includes intrinsic inductance L depicted as inductor 606 and parasitic capacitance C depicted as capacitors 610 and 612, arranged in a "pi" (π) model for illustration purposes. A first terminal of the inductor 606 connected at the node labeled P1 and a second terminal of the inductor 606 connected at the node labeled P2. Each of the capacitors 610 and 612 are representative of half of the parasitic capacitance (e.g., C/2) with a first terminal of capacitor 610 connected at the P1 node, a first terminal of capacitor 612 connected at the P2 node, and second terminals of capacitors 610 and 612 connected at a ground supply node labeled GND.

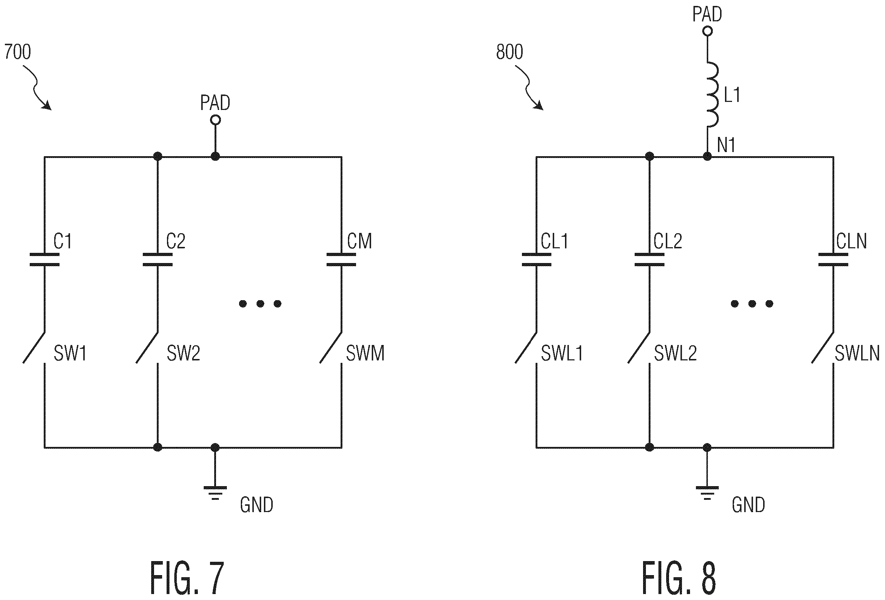

The tunable capacitor 602, the transmission line 604, and the tunable inductor 608 correspond to the tunable capacitor 512, the transmission line 506, and the tunable inductor 518 of FIG. 5, for example. A first terminal of the transmission line 604 is connected at the P1 node and a second terminal of the transmission line 604 is connected at a first terminal of the tunable capacitor 602. A second terminal of the tunable capacitor 602 is connected at the GND node. A first terminal of the tunable inductor 608 is connected at the P2 node and a second terminal of the tunable inductor 608 is connected at the GND node. In this embodiment, the tunable capacitor 602, the transmission line 604, and the tunable inductor 608 are configured for resonating out parasitic impedances associated with the signal pad portion 614. By resonating out the parasitic impedances in this manner, a virtually loss-less semiconductor die to package substrate transition (108 of FIG. 1 and FIG. 2) may be realized. For reference, an alternative example schematic of a tunable capacitor is depicted in FIG. 7 and an alternative example schematic of a tunable inductor is depicted in FIG. 8.

FIG. 7 illustrates, in a simplified schematic view, an example tunable capacitor circuit 700 in accordance with an embodiment. The tunable capacitor 700 depicted in FIG. 7 is provided as an alternative example implementation of the tunable capacitor 512 depicted in FIG. 5, for example. The tunable capacitor 700 includes a plurality of capacitors C1-CM (e.g., where M equals the number of selectable branches of the tunable capacitor) coupled in a parallel configuration between a node labeled PAD (corresponding to the signal pad 104 of FIG. 5) and the ground supply node GND. Each capacitor C1-CM of the plurality of capacitors is enabled by way of a corresponding unique switch SW1-SWM. For example, a first branch of the parallel configuration includes the capacitor C1 coupled in series with the switch SW1, a second branch of the parallel configuration includes the capacitor C2 coupled in series with the switch SW2, and an M-th branch of the parallel configuration includes the capacitor CM coupled in series with the switch SWM. The switches SW1-SWM may be implemented as MOSFETs or other suitable circuit elements configurable as an "ON-OFF" type switch. Each switch SW1-SWM includes a control electrode (not shown) for independently controlling whether the switch is ON (e.g., closed, conducting) or OFF (e.g., open, non-conducting). For example, for each switch turned ON, the respective capacitor of the branch is coupled at the PAD node thus affecting the capacitance value coupled at the PAD node. Control circuitry coupled to the control electrodes of the switches SW1-SWM is not shown for illustration purposes.

FIG. 8 illustrates, in a simplified schematic view, an example tunable inductor circuit 800 in accordance with an embodiment. The tunable inductor 800 depicted in FIG. 8 is provided as an alternative example implementation of the tunable inductor 518 depicted in FIG. 5, for example. The tunable inductor 800 includes an inductor L1 coupled in series with a plurality of capacitors CL1-CLN (e.g., where N equals the number of selectable branches of the tunable inductor) coupled in a parallel configuration. The inductor L1 includes a first terminal coupled at the PAD node (corresponding to the signal pad 104 of FIG. 5) and a second terminal coupled at a node labeled N1. The parallel configuration of the plurality of capacitors CL1-CLN is coupled between the N1 node and the GND node.

Each capacitor CL1-CLN of the plurality of capacitors is enabled by way of a corresponding unique switch SWL1-SWLN. For example, a first branch of the parallel configuration includes the capacitor CL1 coupled in series with the switch SWL1, a second branch of the parallel configuration includes the capacitor CL2 coupled in series with the switch SWL2, and an N-th branch of the parallel configuration includes the capacitor CLN coupled in series with the switch SWLN. The switches SWL1-SWLN may be implemented as MOSFETs or other suitable circuit elements configurable as an "ON-OFF" type switch. Each switch SWL1-SWLN includes a control electrode (not shown) for independently controlling whether the switch is ON (e.g., closed, conducting) or OFF (e.g., open, non-conducting). For example, for each switch turned ON, the respective capacitor of the branch is coupled at the N1 node thus affecting the inductance value coupled at the PAD node. Control circuitry coupled to the control electrodes of the switches SWL1-SWLN is not shown for illustration purposes.

Generally, there is provided, a semiconductor device including a semiconductor die having an active side; a signal pad formed at the active side of the semiconductor die; and a plurality of power amplifiers, each power amplifier of the plurality of power amplifiers having an output interconnected with the signal pad by way of a unique signal trace, the signal pad configured to function as a power combiner for the plurality of power amplifiers.

The unique signal traces may be configured to form symmetrical signal paths between the outputs of the power amplifiers and the signal pad. The semiconductor device may further include a ground pad formed at the active side of the semiconductor die, the ground pad connected to a ground plane proximate to the signal pad. The ground plane may be configured to substantially surround the signal pad, the ground plane uniformly spaced apart from the signal pad by a predetermined distance. A first unique signal trace may have a first end connected at a first side of the signal pad and a second end connected at the output of a first power amplifier of the plurality of power amplifiers, and a second unique signal trace may have a first end connected at a second side of the signal pad opposite of the first side and a second end connected at the output of a second power amplifier of the plurality of power amplifiers. The semiconductor device may further include a package substrate, the semiconductor die interconnected with the package substrate by way of a plurality of die connectors. The signal pad of the semiconductor die may be interconnected with a signal trace of the package substrate, the signal trace substantially shielded to form a coaxial signal path through the package substrate.

In another embodiment, there is provided, a semiconductor device including a semiconductor die having an active side; a signal pad formed at the active side of the semiconductor die; a transmission line formed at the active side of the semiconductor die, the transmission line having a first end connected to the signal pad; a ground pad formed at the active side of the semiconductor die, the ground pad connected to a ground plane proximate to the signal pad; and a tunable inductor having a first terminal connected to the signal pad and a second terminal connected to the ground plane. The tunable inductor may be formed as a plurality of substantially symmetrical trace segments which extend radially from the signal pad to the ground plane. The tunable inductor may be configured to compensate for parasitic capacitance associated with the signal pad. The semiconductor device may further include a plurality of power amplifiers formed at the active side of the semiconductor die, each power amplifier of the plurality of power amplifiers having an output coupled to the transmission line. The output of each power amplifier of the plurality of power amplifiers may be coupled to a second end of the transmission line by way of a power combiner network. The semiconductor device may further include a tunable capacitor having a first terminal connected to the transmission line and a second terminal connected to the ground plane. The tunable capacitor may be formed as a metal-insulator-metal (MIM) capacitor, a portion of the transmission line configured as first plate of the MIM capacitor. The tunable capacitor includes a plurality of capacitors in a parallel configuration, each capacitor of the plurality of capacitors is enabled by way of a unique switch.

In yet another embodiment, there is provided, a method including forming a signal pad at an active side of a semiconductor die; forming a plurality of power amplifiers at the active side of the semiconductor die, each power amplifier of the plurality of power amplifiers having an output; and interconnecting the output of each power amplifier of the plurality of power amplifiers with the signal pad by way of a unique signal trace, the signal pad configured to function as a power combiner for the plurality of power amplifiers. The method may further include forming a ground pad at the active side of the semiconductor die, the ground pad connected to a ground plane proximate to the signal pad. The unique signal traces may be configured to form symmetrical signal paths between the outputs of the power amplifiers and the signal pad. The method may further include mounting the semiconductor die on a package substrate, the semiconductor die interconnected with the package substrate by way of a plurality of die connectors. The signal pad of the semiconductor die may be interconnected with a signal trace of the package substrate, the signal trace substantially shielded to form a coaxial signal path through the package substrate.

By now, it should be appreciated that there has been provided a semiconductor device having a low loss die-to-substrate package transition. The semiconductor device includes a semiconductor die mounted on a low-cost package substrate. The semiconductor die includes a die pad configuration formed at an active side having a signal pad substantially surrounded by a plurality of ground pads. The signal pad is configured for propagation of extremely high frequency band signals. The die pad configuration of the semiconductor die employs features to preserve electromagnetic field symmetry and to resonate out parasitic impedances. The signal pad and surrounding plurality of ground pads of the semiconductor die are interconnected with corresponding exposed traces of the package substrate by way of die connectors to form a compact die-to-substrate transition. The package substrate includes ground planes, traces, and vias configured to substantially surround and shield the signal traces to form a coaxial signal path through the package substrate. By forming the semiconductor device in this manner, a virtually loss-less semiconductor die-to-substrate package transition may be realized which allows higher performance at lower costs.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A semiconductor device comprising:
a semiconductor die having an active side;
a signal pad formed at the active side of the semiconductor die; and
a plurality of power amplifiers, each power amplifier of the plurality of power amplifiers having an output interconnected with the signal pad by way of a unique signal trace, the signal pad configured to function as a power combiner for the plurality of power amplifiers.

2. The semiconductor device of claim 1, wherein the unique signal traces are configured to form symmetrical signal paths between the outputs of the power amplifiers and the signal pad.

3. The semiconductor device of claim 1 or 2, further comprising a ground pad formed at the active side of the semiconductor die, the ground pad connected to a ground plane proximate to the signal pad.

4. The semiconductor device of claim 3, wherein the ground plane is configured to substantially surround the signal pad, the ground plane uniformly spaced apart from the signal pad by a predetermined distance.

5. The semiconductor device of any preceding claim, wherein:
a first unique signal trace has a first end connected at a first side of the signal pad and a second end connected at the output of a first power amplifier of the plurality of power amplifiers, and
a second unique signal trace has a first end connected at a second side of the signal pad opposite of the first side and a second end connected at the output of a second power amplifier of the plurality of power amplifiers.

6. The semiconductor device of any preceding claim, further comprising a package substrate, the semiconductor die interconnected with the package substrate by way of a plurality of die connectors.

7. The semiconductor device of claim 6, wherein the signal pad of the semiconductor die is interconnected with a signal trace of the package substrate, the signal trace substantially shielded to form a coaxial signal path through the package substrate.

8. The semiconductor device of claim 3 or ny claim depending therefrom, wherein a tunable inductor is formed as a plurality of substantially symmetrical trace segments which extend radially from the signal pad to the ground plane.

9. The semiconductor device of claim 8, wherein the tunable inductor is configured to compensate for parasitic capacitance associated with the signal pad.

10. The semiconductor device of claim 8 or 9, further comprising a tunable capacitor having a first terminal connected to the transmission line and a second terminal connected to the ground plane.

11. A method comprising:
forming a signal pad at an active side of a semiconductor die;
forming a plurality of power amplifiers at the active side of the semiconductor die, each power amplifier of the plurality of power amplifiers having an output; and
interconnecting the output of each power amplifier of the plurality of power amplifiers with the signal pad by way of a unique signal trace, the signal pad configured to function as a power combiner for the plurality of power amplifiers.

12. The method of claim 11, wherein further comprising forming a ground pad at the active side of the semiconductor die, the ground pad connected to a ground plane proximate to the signal pad.

13. The method of claim 11 or 12, wherein the unique signal traces are configured to form symmetrical signal paths between the outputs of the power amplifiers and the signal pad.

14. The method of any of claims 11 to 13, further comprising mounting the semiconductor die on a package substrate, the semiconductor die interconnected with the package substrate by way of a plurality of die connectors.

15. The method of claim 14, wherein the signal pad of the semiconductor die is interconnected with a signal trace of the package substrate, the signal trace substantially shielded to form a coaxial signal path through the package substrate.
